Europäisches Patentamt

European Patent Office

Office européen des brevets

(11) Publication number: **0 095 306**
**B1**

## (12) EUROPEAN PATENT SPECIFICATION

(45) Date of publication of patent specification: 29.06.88

(21) Application number: 83302781.6

(22) Date of filing: 17.05.83

(51) Int. Cl.⁴: **H 01 L 23/52,** H 01 L 25/04,
H 01 L 23/14

(54) Flex-pack interconnection carrier.

(30) Priority: 21.05.82 US 380582

(43) Date of publication of application:
30.11.83 Bulletin 83/48

(45) Publication of the grant of the patent:
29.06.88 Bulletin 88/26

(84) Designated Contracting States:
BE DE FR GB NL SE

(56) References cited:
DE-A-1 591 513
DE-A-2 706 467
DE-A-2 836 092
GB-A-1 048 021
GB-A-2 063 571
US-A-3 984 739
US-A-4 092 057

(73) Proprietor: **UNISYS CORPORATION**
**Burroughs Place**
**Detroit Michigan 48232 (US)**

(72) Inventor: **Stopper, Herbert**
**4221 Norman Wood Drive**
**Orchard Lake, MI 48033 (US)**

(74) Representative: **Kirby, Harold Douglas Benson**
**et al**
**G.F. Redfern & Company Marlborough Lodge 14**
**Farncombe Road**
**Worthing West Sussex BN11 2BT (GB)**

Courier Press, Leamington Spa, England.

## Description

Background of the invention

This invention relates to an interconnection carrier for mounting a plurality of semiconductor wafers.

In the prior art there are numerous devices for packaging semiconductor wafers. The usual practice is to mount the wafers as discrete dies in a ceramic package. For instance IBM has recently announced use of a 64 chip package with a plurality of chips mounted in a single package, with gold solder connecting the chips to pins of the package, and the package pins being used to plug the package into the printed circuit board.

While ceramic chips are generally preferred, plastic packages are also commonly used for chips.

These plastic packages have often been made of polyimides. Polyimides have also been used in the manufacture of flexible cable circuits.

Illustrative of the prior art is a number of patents having to do with a flexible circuit assembly, wherein Tommy L. Walton is the inventor. Many of the manufacturing techniques relating to the present invention are disclosed in such patents as United States Patent No. 4,092,057, issued May 30, 1978; U.S. Patent No. 4,026,011 and U.S. Patent No. 4,075,420 issued February 21, 1978.

DE—A—1 591 513 discloses an arrangement in which a number of printed circuit boards are mechanically interconnected by a flexible web. In addition metal lines are provided on the web to electrically interconnect the printed circuit boards. Contact pads are provided on the printed circuit boards to connect the whole assembly to external circuits. The web can be folded so that the printed circuit boards are parallel to one another without disturbing the metal connections provided on the web.

This invention specifically relates to a flex pack interconnection carrier for a plurality of electrical devices comprising a plurality of support members consisting of substantially rigid insulating material, a web of flexible insulating material mechanically interconnecting said support members, metal circuits provided on said support members and said web to electrically interconnect said electrical devices and at least one contact pad provided on at least one of said support members to provide electrical interconnection between at least one of said electrical devices and a further device external to said carrier, said carrier being capable of being folded at the mechanical interconnection between said support members formed by said web without interrupting said electrical interconnections.

The invention is characterised in that each of said electrical devices is an integrated circuit wafer and each of said support members has a window in which a respective one of said wafers is inserted and bonded, and in that said web comprises a plurality of arms radiating from a central portion, each of said arms mechanically interconnecting two of said support members and said arms being arranged so that when said carrier has been folded along the length of each of said arms, all said support members lie one on top of the other.

Detailed description of the drawings

The following description will refer to the appended drawings, in which:

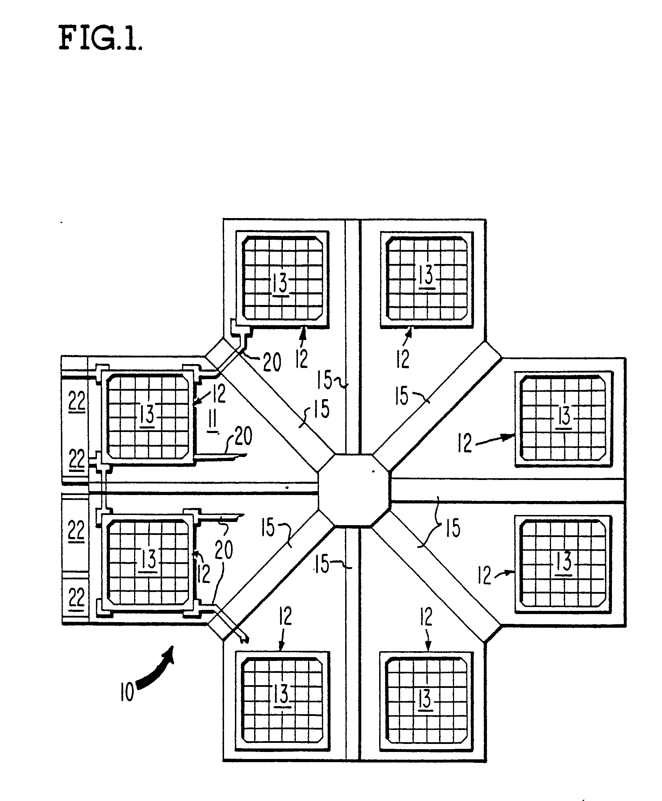

Figure 1 is a plan view of the flex-pack interconnection carrier in accordance with the preferred embodiment of my invention.

Figure 2, is a view of the folded flex-pack interconnection carrier of Figure 1, illustrating the connection of the pack to a board interconnect device.

Referring to the foregoing drawings in greater detail, eight substantially flat support members are arranged as shown interconnected by a flexible membrane. Each of the support members 11 have a rectangular window 12 for support of a wafer 13 which is mounted therein.

The flat support members 11 are quadrilaterals having angles of 90° at the outer ends and edges of the flex-pack interconnection carrier 10. At the center of the flex-pack interconnection carrier 10 each of the support members come to a point as shown and have an acute angle there of approximately 45°. The other internal angle of the quadrilateral support members 11 is approximately 135°.

In the preferred embodiment, each support member is approximately 62 mils thick between the outer and inner surfaces. These support members 11 serve as an insulating substrate and can be made of typical circuit board materials such as glass fiber base epoxy, paper base phenolic, or random glass fiber polyester. This group of materials includes NEMA (National Electronics Manufacturers Association) XXXP; XXXPC; FR 2, 3, 4 and 5; G10 and G11; and FR-6. As will become evident later in this description, the material for support members 11 is chosen to be that desired for the rigid connectors to the circuit assembly.

The support members 11 are interconnected by a flexible web 15. This flexible web is laminated to the rigid support members during the course of manufacture of the flex-pack interconnection carrier 10. This flexible web is made of thermosetting polyimide, such as that sold by E.I. du Pont de Nemourse and Company, Inc. under the trademark KAPTON. Other materials which may be used for insulating film include polyvinyl chloride, polytetrafluoroethylene, and the like. The flex-pack web is made as a flexible sheet laminate approximately $7.62 \times 10^{-5}$ m (three mils) in thickness by compression molding at 218.3°C, 206.7 bar (425°F, 3000 p.s.i.) in 2—10 minute cycles, or alternatively by free sintering with the support substrate 11 at 248.8°C (480°F) for 15—30 seconds at 1033.5 bar (15,000 p.s.i.) cold forming.

Interconnection leads are made on the flex-pack interconnection carrier 10 by electroplating on the outer surface of the insulating materials constituting the support members 11 and the web 15. The electroplating forms a layer of metal, preferably copper, which is evenly distributed on the finished insulating materials.

This copper layer can be plated directly on the insulating materials or a metallic clad insulating film may be bonded thereto which already bears the metal on the surface. Such a preferred film is that distributed by Fortin Laminating Corporation of San Fernando, California, U.S.A. under the trade name "Poly-Core EPO31C03." This may be laminted to the carrier 10 by laminating the layers together in a heated hydraulic press at 171.1°C (340°F.) at a pressure of 3.45—34.5 bar (50—500 p.s.i.) for 45—60 minutes.

The next step in manufacture is to etch the metal layer to form the desired spaced conductors 20 on the support members 11 and the web 15. Portions of a tab 22 of the support members which is used as a contact tab 22 for connection to the socket 30 are also etched at the same time. One or more of the support members may have a contact tab, and the configuration of the conductors 20 and number of tabs 22 is a matter of individual designer preference.

The copper layer can be etched using known photolithographic techniques known in flexible circuit technology. Briefly, this is accomplished by applying a photoresist to copper layered support members 11 and web 15 and exposing a desired circuit pattern using opaque masks, and then developing the resist. The developed photo resist is then washed away leaving selected portions of the copper layer exposed in the desired circuit pattern. A thin layer of tin and lead alloy is then electroplated onto the exposed copper. The remaining photoresist is then stripped away. Then the portions of the copper layer which are not covered by the tin and lead alloy are then etched away using a suitable etchant such as ammonium persulfate.

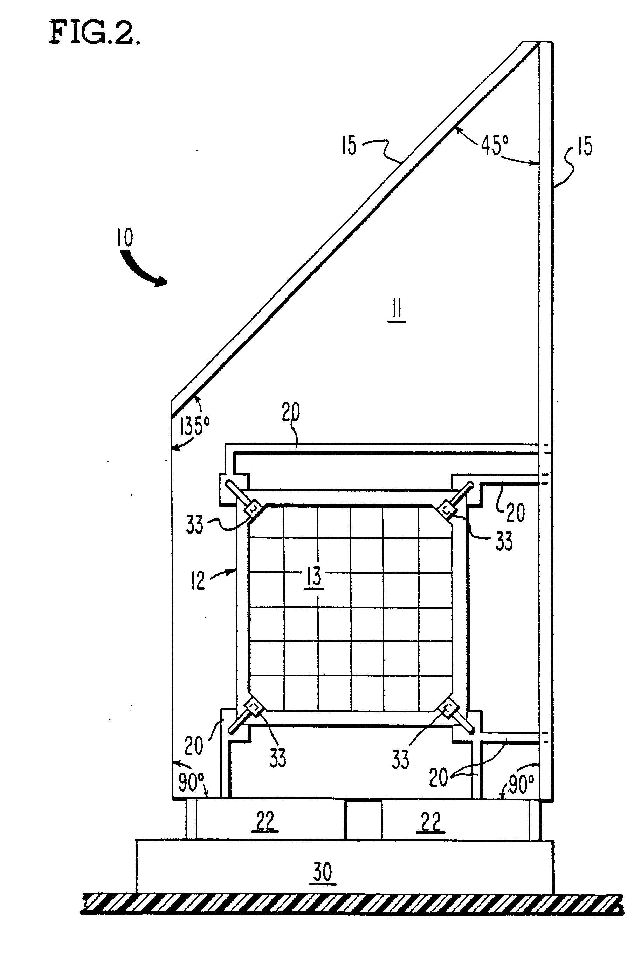

The contact pads terminate at the selected outer edges of the support members 11. After insertion and bonding of the wafer in the windows 12, the flex pack is folded along the arms of the web 15 to the configuration shown in Figure 2 and inserted in the contact socket.

The wafers which are inserted in the windows have a plurality of pads, usually two to four, for both serial signal entry and power. These pads 33 are bonded with gold to the conductors which have been etched on the support members. They are first placed in the windows and bonded in place with epoxy adhesive. Then the bonds to the support member circuit are made.

## Claims

1. A flex pack interconnection carrier (10) for a plurality of electrical devices (13) comprising a plurality of support members (11) consisting of substantially rigid insulating material, a web (15) of flexible insulating material mechanically interconnecting said support members, metal circuits provided on said support members and said web to electrically interconnect said electrical devices and at least one contact pad (22) provided on at least one of said support members to provide electrical interconnection between at least one of said electrical devices and a further device external to said carrier, said carrier being capable of being folded at the mechanical interconnection between said support members formed by said web without interrupting said electrical interconnections, characterised in that each of said electrical devices (13) is an integrated circuit wafer and each of said support members (11) has a window (12) in which a respective one of said wafers (13) is inserted and bonded, and in that said web (15) comprises a plurality of arms radiating from a central portion, each of said arms mechanically interconnecting two of said support members and said arms being arranged so that when said carrier has been folded along the length of each of said arms, all said support members lie one on top of the other.

2. A flex pack interconnection carrier according to Claim 1, wherein there are eight substantially identical support members.

3. A flex pack interconnection carrier according to Claim 2, wherein each of said support members is shaped as a quadrilateral with two 90° internal angles and the other two internal angles being 45° and 135°.

## Patentansprüche

1. Flexibler Verbindungsträger (10) für eine Mehrzahl von elektrischen Anordnungen (13) mit einer Mehrzahl von Trägerkörpern (11), die aus im wesentlichen festem Isoliermaterial bestehen; mit einer Bahn (15) aus flexiblem Isoliermaterial, die die Trägerkörper mechanisch untereinander verbindet; mit Metallschaltungen, die auf den Trägerkörpern und der Bahn angebracht sind und die elektrischen Anordnungen und mindestens eine Kontaktfläche (22) auf mindestens einem der Trägerkörper miteinander verbinden, um elektrische Verbindungen zwischen mindestens einer der elektrischen Anordnungen und einer weiteren, gegenüber dem Verbindungsträger externen Anordnung herzustellen; wobei der Verbindungsträger an der durch die Bahn gebildeten mechanischen Verbindung zwischen den Trägerkörpern gefaltet werden kann, ohne daß die elektrischen Verbindungen unterbrochen werden; dadurch gekennzeichnet, daß jeder der elektrischen Anordnungen (13) ein integiertes Schaltungsplättchen ist; daß jeder der Trägerkörper (11) ein Fenster (12) aufweist, in das ein entsprechendes Schaltungsplättchen (13) eingesetzt und befestigt ist; daß die Bahn (15) eine Mehrzahl von Armen aufweist, die sich von einem zentralen Teil radial erstrecken und von denen jeder Arm zwei der Trägerkörper miteinander verbindet; und daß die Arme so angeordnet sind, daß alle Trägerkörper aufeinanderliegen, wenn der Verbindungsträger entlang der Länge jedes der Arme gefaltet worden ist.

2. Flexibler Verbindungsträger nach Anspruch 1, dadurch gekennzeichnet, daß acht im wesentlichen gleiche Verbindungskörper vorgesehen sind.

3. Flexibler Verbindungsträger nach Anspruch 2, dadurch gekennzeichnet, daß jeder der Verbindungskörper viereckig mit zwei eingeschlossenen Winkeln von 90° und zwei weiteren eingeschlossenen Winkeln von 45° bzw. 135° ausgebildet ist.

### Revendications

1. Support d'interconnexion à conditionnement souple (10) pour un ensemble de dispositifs électriques (13) comportant un ensemble d'éléments de support (11) formés en un matériau d'isolation essentiellement rigide, une nappe (15) de matière isolante souple reliant mécaniquement les éléments de support, des circuits métalliques étant réalisés sur les éléments de support et la nappe pour relier électriquement les dispositifs électriques et au moins l'un des patins de contact (22) prévu sur au moins l'un des éléments de support pour réaliser la liaison électrique entre au moins l'un des dispositifs électriques et un autre dispositif extérieur au support, le support pouvant être plié au niveau de l'interconnexion mécanique entre les éléments de support formés par la nappe sans couper les interconnexions électriques, support caractérisé en ce que chacun des dispositifs électriques (13) est une plaquette de circuit intégré et chacun des éléments de support (11) a une autre fenêtre (12) qui reçoit l'une des plaquettes (13) qui y est collée et en ce que la nappe (15) est formée d'un ensemble de bras rayonnants à partir d'une partie centrale, chacun des bras reliant mécaniquement deux des éléments de support et les bras étant disposés de façon que lorsque le support est plié suivant la longueur de chacun des bras, tous les éléments de support se trouvent l'un au-dessus de l'autre.

2. Support d'interconnexion à conditionnement souple selon la revendication 1, caractérisé par huit éléments de support pratiquement identiques.

3. Support d'interconnexion à conditionnement souple selon la revendication 2, caractérisé en ce que chacun des éléments de support a la forme d'un quadrilatère à angles internes de 90° et dont les deux autres angles internes sont respectivement égaux à 45° et 135°. ·

# FIG.1.

FIG.2.